(19) Europäisches Patentamt
European Patent Office
Office européen des brevets

(11) **EP 4 311 097 A1**

(12) **EUROPEAN PATENT APPLICATION**

(43) Date of publication:
**24.01.2024  Bulletin 2024/04**

(21) Application number: **22186399.6**

(22) Date of filing: **22.07.2022**

(51) International Patent Classification (IPC):
**H02N 2/00** *(2006.01)*          **H02N 2/02** *(2006.01)*
**H02N 2/10** *(2006.01)*

(52) Cooperative Patent Classification (CPC):
**H02N 2/001; H02N 2/0005; H02N 2/0055;
H02N 2/026; H02N 2/103**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **MINISWYS SA
2502 Biel (CH)**

(72) Inventor: **The designation of the inventor has not
yet been filed**

(74) Representative: **Frei Patent Attorneys
Frei Patentanwaltsbüro AG
Hagenholzstrasse 85
8050 Zürich (CH)**

(54)    **SHOCK RESISTANT DRIVE UNIT**

(57)    A drive unit for driving a passive element (4) relative to an active element (1), comprises a resonator (2) and an excitation means (23), and two arms (21, 22) with contact elements (31, 32) that are movable by way of oscillating movements and thereby drive the passive element (4).

The resonator (2) is attached to a base element (5) by means of fixation elements (29). For at least **a first arm** (21) and for its contact element (31, 32) there is a **shortest path** through the active element 1 to a **nearest fixation element** (29). The shortest path does not intersect an **outline** of the excitation means (23), or, of it does, the area of an overhanging portion of the excitation means (23) is less than ten percent of an area of the excitation means (23).

As a result, the excitation means are less likely to break due to forces on the arms.

**Fig. 3**

EP 4 311 097 A1

**Description**

The invention relates to the field of miniaturised drives, for example piezoelectric drives. More particularly, it relates to a drive unit as described in the preamble of the independent claims.

Such drives are disclosed, for example, in the applicant's WO 2006/000118 A1 or US 7'429'812 B2, WO 2019/068708 A2, WO 2020/229290 A1, WO 2021/037779 A1 and WO 2021/209 559 A1. There is a need for further improvement of such drives, in particular by making them resistant to failure due to mechanical shocks and/or due to fatigue failure.

More particularly, it is desirable to have a small overall length of such a drive, seen in the direction in which the arms extend. This is contrary to the need of having a minimal length of the arms, so that they can oscillate in a frequency range that is optimal in view of further constraints. The effectively oscillating length of the arms can be increased by joining the arms to respective connection regions of the drive at arm attachment regions that are located under an excitation means. A part of the arms that is designed to oscillate can be attached to the excitation means with a relatively elastic bonding agent (relative to the excitation means and the resonator). So, the arm in a region bonded to the excitation means is still able to oscillate with amplitudes required for operating the drive. However, it has been found that the excitation means is prone to crack or break in the region where the arm is bonded to the excitation means.

It is therefore an object of the invention to create a drive unit of the type mentioned initially, which overcomes the disadvantages mentioned above.

These objects are achieved by a drive unit according to claim 1.

A drive unit serves for driving a passive element relative to an active element, wherein the active element comprises

- a resonator and at least one excitation means for exciting oscillations in the resonator,
- the resonator comprising **at least two arms** extending from a connection region of the resonator,
- the resonator and the at least two arms extending in parallel to a reference plane,
- the at least one excitation means extending in parallel to the reference plane and being attached to the resonator at a **contact area,**
- at least one of the at least two arms comprising, at an **outer end** of the arm, a corresponding contact element,
- the contact element being movable by way of oscillating movements of the corresponding arm,
- the passive element being arranged to be driven and moved relative to the active element by way of these oscillating movements;
- the passive element comprises at least one contact areas, each contact area being arranged to be in contact with a corresponding contact element,

Therein, the resonator is attached to a base element by means of at least one fixation element. In embodiments, it is the case that the fixation element is arranged relative to the connection region in a direction in which the arms extend, or in a direction normal to the direction in which the arms extend. In embodiments, the fixation element is arranged relative to the connection region in a direction opposite to the direction in which the arms extend.

For at least a **first arm** of the at least two arms, for its contact element there is a **shortest path** through the active element to a **nearest fixation element** of the at least one fixation elements, and the following condition is satisfied:

- in a projection onto the reference plane, the shortest path does not intersect an **outline** of the excitation means, and thus does not pass through a portion of the excitation means that overhangs the resonator, or
- if the shortest path *does* pass through a portion of the excitation means that overhangs the resonator, then, in the projection onto the reference plane, an area of this overhanging portion is less than ten percent of an area of the excitation means, in particular less than five percent, in particular less than two percent.

In embodiments with a second arm, this also can hold for a further shortest path from the second contact element to its nearest fixation element.

In embodiments, the condition is satisfied for two of the at least two arms and in particular for all arms of the at least two arms.

The fixation element being arranged as described above (relative to the connection region in a direction in which the arms extend, or in a direction normal to the direction in which the arms extend) excludes drive units in which there one or more fixation elements are arranged exclusively in a direction away from the direction in which the arms extend, that is, at a side of the connection region opposite to the side from which the arms extend.

So, there is at least one fixation element as described above, and for each of the contact elements, there is a nearest fixation element, and a corresponding shortest path.

The shortest path constitutes a direct force path along which most of forces acting on the outer end of the arm are transmitted to the fixation element. Such forces can be parallel to but also normal to the reference plane.

It has been determined that the reason for the cracking of the excitation means observed in the prior art is that mechanical shock to the drive can cause inertial forces on an arm, which in turn can cause excessive forces to act on the excitation means, depending on how the arms and the excitation means are shaped and attached to one another. As the excitation means typically is a relatively stiff and hard piezo crystal, it can crack.

In embodiments, if the shortest path between a contact element and the nearest fixation element passes through an overhanging portion of the piezo, the maximum stress in the piezo, when applying an acceleration of 100'000 g in a direction perpendicular to the arm extension and comprised in the excitation means plane, remains below 100MPa. This value is a typical piezo tensile strength.

Providing for a path by which forces acting on the arms are transmitted to the fixation element with only minimally or not at all affecting the excitation means reduces or altogether eliminates the cause for the excitation means cracking.

If the shortest path does not intersect the outline of the excitation means at all, the resonator material will absorb most of the movement of the arm in the case of a shock.

If the shortest path does intersect the outline, then the likelihood of cracking increases with the size of the overhanging portion.

The overhanging portion of the excitation means is a part of the excitation means for which, in the projection onto the reference plane, the resonator is not present.

The width of the excitation means can be defined as the extension of the excitation means in the direction of the resonator axis. The outline of the excitation means is its outline as seen in a projection on the reference plane. Typically, the outline is rectangular. Typically, the excitation means is a rectangular piezo element.

In embodiments, statements made about the first arm and its associated first contact element and first arm attachment region etc. also apply to a second arm of the at least two arms and its corresponding second contact element and arm attachment region etc.

In embodiments with a second arm, there can be a further shortest path from the second contact element through the resonator, a fixation element, wherein this fixation element can be the same as the one associated with the shortest path for the first arm, or a separate, further fixation element.

In embodiments, the nearest fixation element is arranged, relative to the connection region, at the same side as the first arm.

In embodiments, the nearest fixation element is arranged on a fixation area of the resonator, the fixation area extending from the connection region in same direction as the first arm, and the resonator comprises a bridge connecting the first arm to the fixation area.

The bridge defines an opening or hole in the resonator, the opening lying between the first arm, the connection region, the fixation area and the bridge. The opening or hole is partly covered by the excitation means. The opening can extend relatively far under the outline of the excitation means (as seen in a projection on the reference plane). Regardless of this, the effect of forces on the arm affecting the excitation means is greatly reduced because the forces are taken over by the bridge.

In embodiments with a second arm, a second bridge can be present, connecting the second arm to the fixation area.

In embodiments, the nearest fixation element is arranged on the first arm between the outer end of the first arm at which the first contact element is arranged and an inner end of the first arm at which the first arm is attached to the connection region.

In embodiments with a second arm, a further nearest fixation element can be arranged on the second arm between the outer end of the second arm at which the second contact element is arranged and an inner end of the at which the second arm is attached to the connection region.

In embodiments, in a projection onto the reference plane, the nearest fixation element is arranged on the resonator at a location that, relative to the excitation means, lies in a direction normal to a direction in which the first arm extends.

In embodiments with a second arm, this also can hold for a further fixation element. Typically, the fixation element and further fixation element are arranged at opposite sides of the resonator relative to the excitation means.

In embodiments, the resonator comprises a lateral extension that distances the fixation element from the connection region.

In embodiments with a second arm, the resonator can comprise a further lateral extension that distances the further fixation element from the connection region, typically in a direction opposite to that of the lateral extension.

In embodiments, the lateral extension comprises a bend.

In embodiments, in a projection onto the reference plane, the connection region comprises a lateral notch that extends into the connection region in a direction normal to a direction in which the first arm extends.

The lateral notch increases the length of the first arm that can oscillate. Thereby, the oscillating frequency of the first arm is reduced, when compared to a resonator and first arm without the lateral notch. The net effect is to have a shorter resonator with an arm or arms of essentially the same oscillation frequency. In embodiments, the lateral notch extends under and is covered by the excitation means.

In embodiments with a second arm, the resonator can comprise a further lateral notch that extends into the connection region in a further direction normal to a direction in which the first arm and second arm extend, the further direction typically being opposite to the direction in which the lateral notch extends.

In embodiments, the resonator is shaped from a flat piece of material, in particular as a single piece, for example, by stamping or laser cutting.

In embodiments, the excitation means comprise a rectangular element, in particular a piezo element, attached to one side of the resonator, and optionally a second such element, attached to the opposite side of the resonator.

In embodiments, the excitation means is attached to the resonator by means of a bonding material, a modulus of elasticity (Young's modulus) of the bonding material being lower than one tenth of the modulus of elasticity of the resonator material.

This allows a slight movement of the resonator relative to the excitation means and allows for more modes of oscillation than a stiffer bonding material would.

In embodiments, the at least one fixation element attaches to a point of fixation on the resonator or to a line of fixation on the resonator.

In embodiments, such points of fixation or lines of fixation are located on point-like or linearly extending regions of the resonator that are nodes of oscillation of the resonator in the modes of oscillation when operating the drive.

In embodiments, one or more of such points of fixation or lines of fixation each have an area that is smaller than five percent, in particular smaller than two percent of a total area of the smallest rectangle circumscribing the resonator (seen in a projection onto the reference plane). In relation to a width of the resonator (in a direction of the resonator normal to the direction in which the arms extend, and within the reference plane), a diameter of such a point of fixation can be smaller than one tenth of the width. In absolute terms this can mean that an area of a point of fixation or a line of fixation is smaller than 0.5 square millimetres, in particular smaller than 0.25 square millimetres. Corresponding resonators can have dimensions of 5 by 10, in particular 4 by 8, in particular 3 by 4 millimetres.

The subject matter of the invention will be explained in more detail in the following text with reference to exemplary embodiments which are illustrated in the attached drawings, which schematically show:

Figure 1-2    prior art drives;
Figure 3       four different views of an active element; and
Figure 4-13   different embodiments of active elements.

In principle, identical or functionally identical parts are provided with the same reference symbols in the figures.

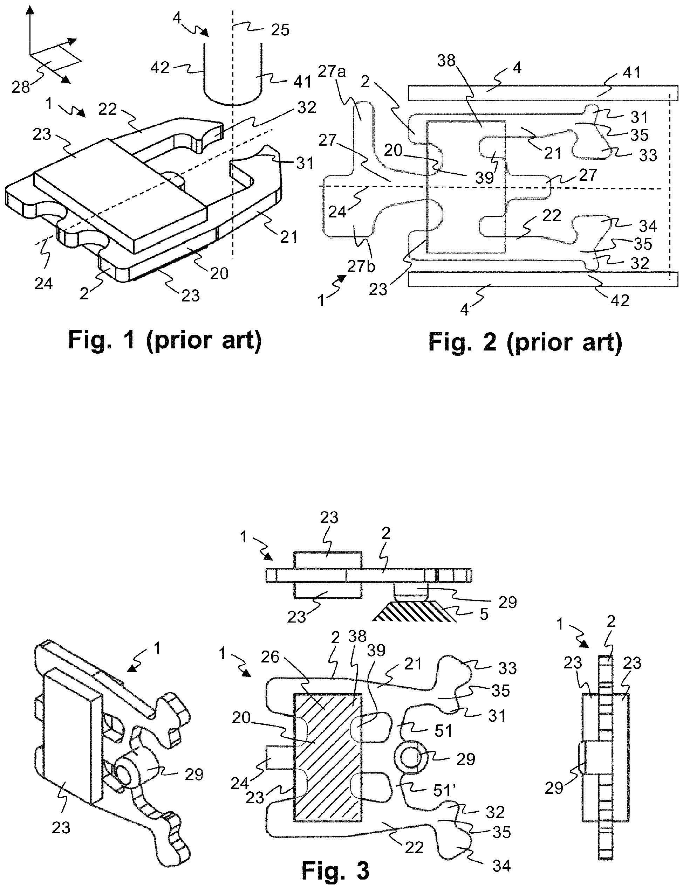

**Figure 1** schematically shows, in an exploded view, elements of a prior art drive unit, with an active element 1 and a passive element 4. The active element 1 comprises a resonator 2 or resonator plate 2 and two excitation means 23. From a connection region 20 of the resonator 2, a first arm 21 and second arm 22 extend in the same direction, corresponding to a resonator axis 24. The resonator 2 and the arms 21, 22 extend in parallel to a reference plane 28. At the end of each arm there are respective first contact elements 31 and second contact elements 32, designed to contact and move the passive element 4 by means of contacting first contact areas 41 and second contact areas 42 of the passive element 4. These contact areas are not necessarily in a fixed relation to the moving passive element 4, rather they are the locations where the contact regions 31, 32 currently contact the passive element 4, as the passive element 4 rotates about a rotary movement axis 25 (in Figure 1) or translates (in Figure 2) relative to the active element 1.

As explained in US 7'429'812 B1 cited above, an excitation frequency of a voltage generator driving the excitation means 23, which can be a piezoelectric element, can be varied, and depending on the frequency different modes of mechanical oscillations of the arms will be generated. For example, in one mode the contact regions 31, 32 will - seen in a projection onto the reference plane - both rotate clockwise, in another both will rotate counter clockwise, and in another one will rotate clockwise and the other one counter clockwise. As another example, in one mode the contact regions 31, 32 will move back and forth at a first angle, and in another mode at a second angle. Depending on the suspension of the passive element, i.e. rotary or linear or combined rotary-linear, the passive element will move accordingly.

The following embodiments operate according to the same basic principles. If not stated otherwise, the elements described so far, if present, have essentially the same function. The arms 21, 22 can be adapted for a movement of linear or of a rotary drive, depending on the embodiment. The location of the excitation means 23 relative to the resonator 2 is represented in a schematic by a rectangle corresponding to the contour of the excitation means 23 attached to one or both sides of the resonator 2.

**Figure 2** shows a prior art linear drive unit with protrusions 33, 34 extending inwards and contact elements extending outwards. The first arm 21 comprises a first protrusion 33 or projection in the direction of the second arm 22. The second arm 22, being essentially the mirror image of the first arm 21 with regard to the resonator axis 24, comprises a second protrusion 34 in the direction of the first arm 21. Thus, both protrusions 33, 34 extend towards the resonator axis 24, that is, towards the inside of the drive.

The first arm 21 comprises a first contact element 31 projecting away from the second arm 22, that is, in a direction opposite to that in which the first protrusion 33 extends. Likewise, the second arm 22 comprises a second contact element 32 projecting away from the first arm 21, in a direction to that in which the second protrusion 34 extends. Thus, both contact elements 31, 32 extend away from the resonator axis 24, that is, towards the outside of the drive. Here they come into contact with the respective first contact area 41 and second contact area 42 of the passive element 4.

The passive element 4 element is schematically represented by two rectangles, corresponding to two linear guides movable in relation to the active element 1. The two guides at the two sides of the passive element 4 are mechanically connected, as represented schematically by a dashed line. The mechanical connection can be rigid, or resilient, in which case it can be part of an arrangement generating a pre-stress acting on the first contact element 31 and second contact element 32 via the first contact area 41 and second contact area 42.

The first protrusion 33 and second protrusion 34 are linked to the remainder of the respective first arm 21 and second arm 22 by a corresponding necking 35. This necking 35 corresponds to a flexurally weaker region along the respective arm. That is, the stiffness of the arm to bending around an axis normal to the reference plane 28 is lower at the necking 35 than in adjacent places. When in operation, with the arms oscillating, each protrusion acts as a counter mass (relative to the respective contact element) and can exhibit an oscillating movement including a small rotation around the respective necking 35. This in turn can lead to a corresponding movement of the respective contact element that is arranged at the same end or the respective arm. This drives the passive elements 4 along a linear movement axis that is parallel to the resonator axis 24.

The resonator 2 can comprise at least one or more fixation or support area(s) 27 at which the resonator is attached to a base (not shown). The fixation area(s) 27 typically is or are located on the resonator axis 24. They typically do not oscillate to a significant degree, being attached to the base. The fixation area(s) 27 can feature additional protrusion(s) such as 27a and 27b to facilitate the electrical connection of the resonator as well as its assembly on a base (not shown). One of the fixation areas 27 shown (the right one in the figure) is arranged relative to the connection region in a direction in which the arms extend, the other one (the left one) in an opposite direction.

**Figure 3** schematically shows four different views of an active element according to a first embodiment: a perspective view (left), a projection onto the reference plane (center), and two projections in directions parallel to the reference plane (top and right).

In addition to elements described in the context of Figure 1 and 2, there is shown:

- A contact area 26, being an area at which the excitation means 23 is attached to the resonator 2, typically by a bonding agent, in particular by a glue. The glue can be an epoxy glue. The glue can be electrically conducting and can serve to power the excitation means 23.

- A fixation element 29 by which the resonator 2 is attached to a base element 5. The fixation element 29 typically constrains movement of the resonator 2, with regard to the base element 5, in all six degrees of freedom.

- A base element 5 representing a device or component in which the active element 1 and the passive element 4 are arranged and are movable with respect to one another.

- Arm attachment regions 38, at which the respective arms are attached to the connection region 20 of the resonator 2. At the arm attachment regions 38, the relatively elastic arms 21, 22 transition into the relatively stiff connection region 20. Movement of the outer ends of the arms (comprising the contact elements 31, 32 and the protrusions 33, 34) is therefore mainly absorbed by the arms.

- A recess 39 in the resonator 2, corresponding to overhanging portion of the excitation means 23. The recess 39 is a region in which, in a projection onto the reference plane 28, the excitation means 23 is present and the resonator 2 is not. In terms of the excitation means 23, the recess 39 is congruent to the overhanging portion of the excitation means 23. If the recess 39 (or overhanging portion) is too large, and no countermeasures are taken, then movement of the outer ends of the arms can cause movement of the arms where the arms and the excitation means 23 overlap, causing a relatively brittle excitation means 23 to crack.

- One or more bridges 51, each bridge 51 being part of the resonator 2 and constituting a link between a respective arm 21, 22 and a fixation element 29. A bridge 51 can create a shortest path from a contact element to the fixation element 29 and absorb forces acting on the outer end of the respective arm, thereby reducing forces acting on the excitation means 23.

The one or more fixation elements 29 by which the resonator 2 is attached to the base element 5 can be implemented in a variety of ways, such as gluing, soldering or welding. Alternatively, or in addition there can be a positive fit, for example, by clamping, a snap-action connection, riveting, or hot stamping (e.g. a stub formed on the base element 5 and passing through a hole in the resonator 2). An area of a point of fixation or of a line of fixation is the area of contact between the resonator 2 and the base element 5, measured in a projection onto the reference plane.

The fixation elements 29 are in a mirror-symmetric arrangement, in particular with a resonator axis 24 being the axis of symmetry.

The active element 1 comprises two excitation means 23 attached to opposite sides of the resonator 2, in particular with the two excitation means 23 having congruent shapes and being arranged in a symmetric arrangement with respect to the resonator 2.

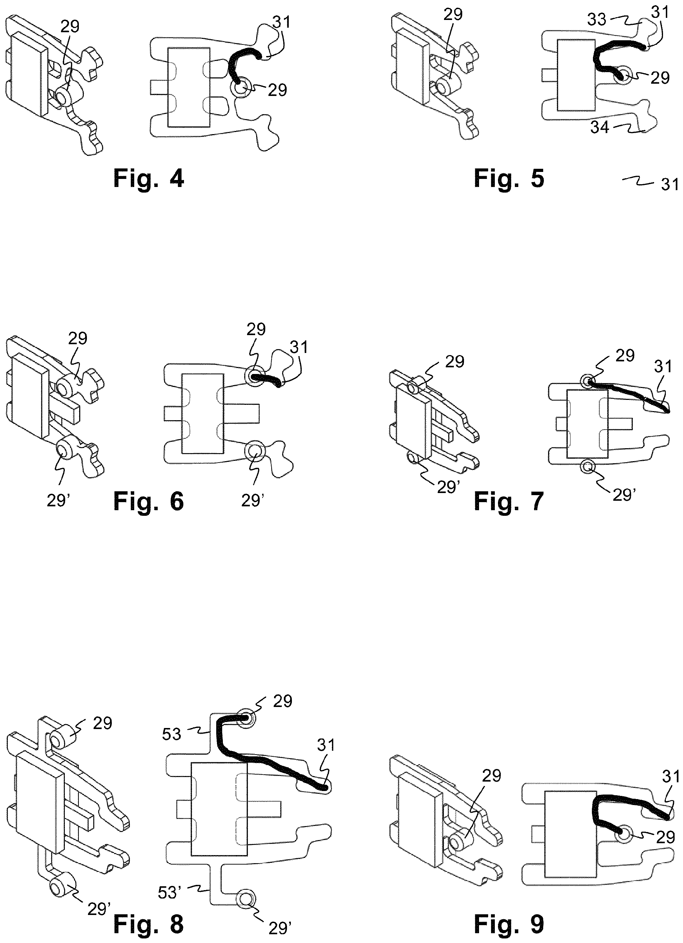

**Figures 4** through **11** each schematically show two different views of an active element according to different embodiments: a perspective view (left) and a projection onto the reference plane (right). For clarity, some reference numbers are omitted. In each case, an approximation to a shortest path for one of the arms is represented by a thick line.

**Figure 4** shows the first embodiment, with the shortest path from the first contact element 31 to a single fixation element 29 located on the resonator axis 24. The shortest path passes through a bridge 51, thereby bypassing the connection region 20 and the excitation means 23.

**Figure 5** shows a second embodiment, with the shortest path from the first contact element 31 to a single fixation element 29 located on the resonator axis 24. The shortest path passes through the resonator 2, and remains within the plane of the resonator 2, without passing through an overhanging region of the excitation means 23.

**Figure 6** shows a third embodiment, with the shortest path from the first contact element 31 to a fixation element 29 located on the first arm 21. The shortest path passes along a short section of the first arm 21, thereby completely avoiding the excitation means 23.

**Figure 7** shows a fourth embodiment, with the shortest path from the first contact element 31 to a fixation element 29 located, relative to the excitation means 23 and the connection region 20, in a direction normal to the direction in which the arms extend. The shortest path passes along the entire first arm 21, and then bypasses the excitation means 23.

**Figure 8** shows a fifth embodiment, with the shortest path from the first contact element 31 to a fixation element 29 located, relative to the excitation means 23 and the connection region 20, in a direction normal to the direction in which the arms extend. The fixation element 29 is distanced from the connection region 20 by a lateral extension 53 of the resonator 2. The lateral extension 53 can be straight, or, as shown in the figure, comprise at least one angle. The lateral extension 53 can lower a resonant frequency of the suspension of the active element 1 relative to the base element 5. In this way, the resonant frequency is moved away from frequency ranges in which the arms are driven.

The shortest path passes along the entire first arm 21, then bypasses the excitation means 23 and then passes along the lateral extension 53.

**Figure 9** shows a sixth embodiment, with a shortest path as in Figure 5, but with the arms not having respective protrusions 33, 34.

In the first to sixth embodiments, and also in the eight to tenth, the shortest path between the contact point and the closest fixation does not cross an overhanging portion of the piezo.

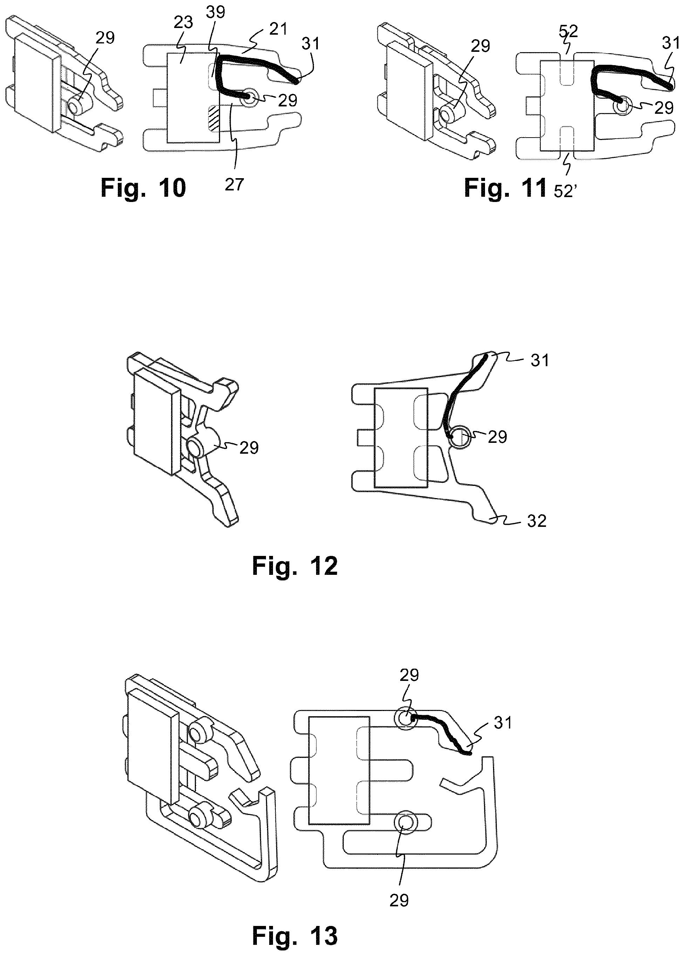

**Figure 10** shows a seventh embodiment, with the shortest path from the first contact element 31 passing along the first arm 21, through the excitation means 23 and through the fixation area 27 to the fixation element 29. The shortest path passes through the excitation means 23, out of the plane of the resonator 2, because there is a recess 39 in the resonator 2. So, the shortest path crosses the overhanging portion of the excitation means 23 (corresponding to the recess 39 in the resonator 2). In in a projection onto the reference plane 28, the shortest path passes through a portion of the excitation means 23 that overhangs the resonator 2. As long as the area of this overhanging portion is less than less than a reference safety factor FSR being ten percent of the area of the excitation means 23, in particular less than five percent, in particular less than two percent, the excitation means 23 is sufficiently unlikely to crack in the event of a shock affecting the first arm 21. In **Figure 10,** for the purpose of illustration, the area of a lower one of the two overhanging portions, in the projection onto the reference plane, which is parallel to the plane of the paper, is hatched. The area of the excitation means 23 equals the area of the rectangular outline of the excitation means 23.

The above upper boundary for the reference safety factor FSR is based on typical dimensions and materials used for the resonator 2 and the excitation means 23, that is, stainless steel 1.4310 and piezo crystal material. For embodiments in which the materials differ, an adapted safety factor FSA can be determined from the reference safety factor FSR on the basis of the following material properties of the resonator 2 and the piezo element acting as excitation means excitation means 23:

- $t\_p$ : thickness of the piezo element,
  with reference value $t\_p\_ref$ = 150 micrometres.
- $s\_p$ : compliance of the piezo element,

with reference value s_p_ref = 15e-12 m2/N.

- E_r : Young's modulus of the resonator material, with reference value E_r_ref = 195 GPa .
- rho r : density of the resonator material, with reference value rho_r_ref = 7900 kg/m3.

Given the properties of an arrangement differing from the reference, the adapted safety factor is

$$FSA = FSR\,(t\_p\ s\_p\ E\_r\ /\ rho\_r)\ /\ (\ rho\_r\_ref\ /\ (t\_p\_ref\ s\_p\_ref\ E\_r\_ref)\ )$$

**Figure 11** shows an eighth embodiment, with the shortest path as in Figures 5 and 9. The resonator 2 comprises, for each arm, an associated notch 52, 52' or lateral notch 52, 52'. The notch extends, from a side of the resonator 2 that faces a direction normal to the direction in which the corresponding arm extends, towards the connection region 20. In other words, the notch 52 extends in a direction normal to the direction in which the arm extends. The notch 52 increases the length of the corresponding arm, lowering its resonant frequency. This allows to shorten the total length of the active element while keeping the resonant frequency of the arm in a desired range.

**Figure 12** shows a ninth embodiment, with the shortest path as in Figure 4, but with the first and second contact elements 31, 32 facing outward.

**Figure 13** shows a tenth embodiment, with the shortest path as in Figure 6, but for an asymmetric drive.

The embodiments can be described as implementing different combinations of features, the features corresponding to a type of drive and to a type of attachment.

Types of drive are:

A. "Inner simple" - inner drive without counter mass (Fig. 7, 9, 10, 11)
B. "Inner counter mass" - inner drive with counter mass at outside at end of arm (Fig. 4, 5, 6)
C. "Outer simple" - outer drive without counter mass (Fig. 12)
D. "Outer counter mass" - outer drive with counter mass at inside of arm (Fig. 2)
E. "Rotary" - asymmetric drive, in particular with one arm oscillating but not driving (Fig. 13)

Further details and the operating principle of the rotary drive are explained in WO 2020/229290 A1, which is hereby incorporated by reference in its entirety. Reference is made in particular to Figs. 3-6 and the associated description.

Types of attachments are:

U. Bridge (Fig. 4, 12)
V. Arm (Fig. 6, 13)
W. Center (Fig. 5, 9, 10)
X. Center with (lateral) notch 52 (Fig. 11)
Y. SideFixation (Fig. 7)
Z. SideFixationExtended (Fig. 8)

Combinations of types of drive and attachment disclosed herein are:

- AU, AV, AW, AX, AY, AZ ;
- BU, BV, BW, BX, BY, BZ;
- CU, CV, CW, CX, CY, CZ;
- DU, DV, DW, DX, DY, DZ ;
- EU, EV, EW, EX, EY, EZ ;

While the invention has been described in present embodiments, it is distinctly understood that the invention is not limited thereto, but may be otherwise variously embodied and practised within the scope of the claims.

**Claims**

1.   A drive unit for driving a passive element (4) relative to an active element (1), wherein the active element (1) comprises

a resonator (2) and at least one excitation means (23) for exciting oscillations in the resonator (2),

the resonator (2) comprising **at least two arms** (21, 22) extending from a connection region (20) of the resonator (2),

the resonator (2) and the at least two arms (21, 22) extending in parallel to a reference plane (28),

the at least one excitation means (23) extending in parallel to the reference plane (28) and being attached to the resonator (2) at a **contact area** (26),

at least one of the at least two arms (21, 22) comprising, at an **outer end** of the arm, a corresponding contact element (31, 32),

the contact element (31, 32) being movable by way of oscillating movements of the corresponding arm (21, 22),

the passive element (4) being arranged to be driven and moved relative to the active element (1) by way of these oscillating movements;

the passive element (4) comprises at least one contact areas (41, 42), each contact area (41, 42) being arranged to be in contact with a corresponding contact element (31,32),

**characterised in that**

the resonator (2) is attached to a base element (5) by means of at least one fixation element (29),

for at least a **first arm** (21) of the at least two arms (21, 22), for its contact element (31, 32) there is a **shortest path** through the active element (1) to a **nearest fixation element** (29) of the at least one fixation elements (29), wherein the following condition is satisfied:

- in a projection onto the reference plane (28), the shortest path does not intersect an **outline** of the excitation means (23), and thus does not pass through a portion of the excitation means (23) that overhangs the resonator (2), or
- if the shortest path *does* pass through a portion of the excitation means (23) that overhangs the resonator (2), then, in the projection onto the reference plane, an area of this overhanging portion is less than ten percent of an area of the excitation means (23), in particular less than five percent, in particular less than two percent.

2. The drive unit of claim 1, wherein the condition is satisfied for two of the at least two arms (21, 22),.and in particular for all arms of the at least two arms (21, 22).

3. The drive unit of claim 1 or claim 2, wherein the nearest fixation element (29) is arranged, relative to the connection region (20), at the same side as the first arm (21).

4. The drive unit of one of claim 1 to claim 3, wherein the nearest fixation element (29) is arranged on a fixation area (27) of the resonator (2), the fixation area (27) extending from the connection region (20) in same direction as the first arm (21), and the resonator (2) comprises a bridge (51) connecting the first arm (21) to the fixation area (27).

5. The drive unit one of claim 1 to claim 3, wherein the nearest fixation element (29) is arranged on the first arm (21) between the outer end of the first arm (21) at which the first contact element (31) is arranged and an inner end of the first arm (21) at which the first arm (21) is attached to the connection region (20).

6. The drive unit of one of claim 1 to claim 2, wherein in a projection onto the reference plane (28), the nearest fixation element (29) is arranged on the resonator (2) at a location that, relative to the excitation means (23), lies in a direction normal to a direction in which the first arm (21) extends.

7. The drive unit of claim 6, wherein the resonator (2) comprises a lateral extension (53) that distances the fixation element (29) from the connection region (20).

8. The drive unit one of claim 1 to claim 3, wherein in a projection onto the reference plane (28), the connection region (20) comprises a lateral notch (52) that extends into the connection region (20) in a direction normal to a direction in which the first arm (21) extends.

9. The drive unit of one of the preceding claims, wherein the fixation elements (29) are in a mirror-symmetric arrangement, in particular with a resonator axis (24) being the axis of symmetry.

10. The drive unit of one of the preceding claims, comprising two excitation means (23) attached to opposite sides of the resonator (2), in particular with the two excitation means (23) having congruent shapes and being arranged in a symmetric arrangement with respect to the resonator (2).

11. The drive unit of one of the preceding claims, wherein the resonator (2) is shaped from a flat piece of material, in particular as a single piece, for example, by stamping or laser cutting.

12. The drive unit of one of the preceding claims, wherein the excitation means (23) comprise a rectangular element, in particular a piezo element, attached to one side of the resonator (2), and optionally a second such element, attached to the opposite side of the resonator (2).

13. The drive unit of one of the preceding claims, wherein the excitation means (23) is attached to the resonator (2) by means of a bonding material, a modulus of elasticity of the bonding material being lower than one tenth of the modulus of elasticity of the resonator material.

14. The drive unit of one of the preceding claims, wherein the at least one fixation element (29) attaches to a point of fixation on the resonator or to a line of fixation on the resonator.

15. The drive unit of one of the preceding claims, wherein the at least one fixation element (29) is arranged relative to the connection region in a direction in which the arms (21, 22) extend, or in a direction normal to the direction in which the arms extend.

Fig. 1 (prior art)

Fig. 2 (prior art)

Fig. 3

**Fig. 4**

**Fig. 5**

31

**Fig. 6**

**Fig. 7**

**Fig. 8**

**Fig. 9**

**Fig. 10**

**Fig. 11**

**Fig. 12**

**Fig. 13**

Europäisches
Patentamt

European
Patent Office

Office européen
des brevets

# EUROPEAN SEARCH REPORT

Application Number

EP 22 18 6399

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 736 965 A1 (MINISWYS SA [CH]) 11 November 2020 (2020-11-11) * paragraphs [0032], [0069], [0077] – paragraph [0080]; figures 3, 8, 9 * | 1-3,6-15 | INV. H02N2/00 H02N2/02 H02N2/10 |
| X | US 2022/216851 A1 (HOESLI RAPHAËL [CH] ET AL) 7 July 2022 (2022-07-07) * paragraph [0139] – paragraph [0144]; figures 8, 9 * | 1 | |
| X | EP 3 787 178 A1 (MINISWYS SA [CH]) 3 March 2021 (2021-03-03) * paragraph [0098] – paragraph [0101]; figures 19, 21 * | 1 | |

TECHNICAL FIELDS
SEARCHED      (IPC)

H02N

The present search report has been drawn up for all claims

| Place of search | Date of completion of the search | Examiner |
|---|---|---|
| Munich | 16 January 2023 | Angermeier, Detlef |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 18 6399

This annex lists the patent family members relating to the patent documents cited in the above-mentioned European search report.
The members are as contained in the European Patent Office EDP file on
The European Patent Office is in no way liable for these particulars which are merely given for the purpose of information.

16-01-2023

| Patent document cited in search report | | Publication date | Patent family member(s) | | Publication date |
|---|---|---|---|---|---|
| EP 3736965 | A1 | 11-11-2020 | NONE | | |
| US 2022216851 | A1 | 07-07-2022 | CN | 113950794 A | 18-01-2022 |
| | | | EP | 3966923 A1 | 16-03-2022 |
| | | | JP | 2022532184 A | 13-07-2022 |
| | | | US | 2022216851 A1 | 07-07-2022 |
| | | | WO | 2020229290 A1 | 19-11-2020 |
| EP 3787178 | A1 | 03-03-2021 | CN | 114303314 A | 08-04-2022 |
| | | | EP | 3787178 A1 | 03-03-2021 |
| | | | EP | 4022762 A1 | 06-07-2022 |
| | | | JP | 2022546059 A | 02-11-2022 |
| | | | US | 2022278633 A1 | 01-09-2022 |
| | | | WO | 2021037779 A1 | 04-03-2021 |

EPO FORM P0459

For more details about this annex : see Official Journal of the European Patent Office, No. 12/82

**EP 4 311 097 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006000118 A1
- WO 2019068708 A2
- WO 2020229290 A1
- WO 2021037779 A1
- WO 2021209559 A1